# EUROPÄISCHE PATENTANMELDUNG

(11) **EP 3 093 878 A1**
(43) Veröffentlichungstag der Anmeldung: **16.11.2016**
(21) Anmeldenummer: 16168750.4
(22) Anmeldetag: 09.05.2016
(51) Int. Cl.: H01L 21/66, H01L 49/02

(54) **MIM-KAPAZITÄT ALS STRESSDETEKTOR**

(30) Priorität: 11.05.2015 DE 102015107325
(71) Anmelder: ROBERT BOSCH GMBH, 70442 Stuttgart (DE)
(72) Erfinder: Dietz, Franz, 72820 Willmandingen (DE); Teng, Lichao, 72764 Reutlingen (DE); Schneider, Daniel, 72800 Eningen Unter Achalm (DE)

(57) **Zusammenfassung**

MIM-Kapazität (1) zur Rissdetektierung umfassend eine erste Metallschicht (2), eine Isolationsschicht (3) und eine zweite Metallschicht (4), wobei die Isolationsschicht (3) zwischen der ersten Metallschicht (2) und der zweiten Metallschicht (4) angeordnet ist, dadurch gekennzeichnet dass die Isolationsschicht (3) eine Bruchzähigkeit kleiner 2MPa √m aufweist.

## Beschreibung

### Stand der Technik

Die Erfindung beschreibt eine MIM-Kapazität zur Rissdetektierung, einen Rissdetektor, einen Halbleiterchip mit einem Rissdetektor und ein Verfahren zur Auswertung des Rissdetektors.

Integrierte Schaltungen bzw. Halbleiterchips beinhalten eine Vielzahl von hochintegrierten Schaltungselementen und Halbleiterbauelementen, die über eine komplexe Metallisierung verbunden sind, z.B. Transitoren, Widerstände oder Kapazitäten.

Nach dem Fertigungsprozess werden die Bauteile über sogenannte Pads elektrisch kontaktiert und in vielen Fällen mit einer Moldmasse umspritzt, die dem hochempfindlichen Schaltkreis mechanischen Schutz während der weiteren Verarbeitung bzw. während des Einsatzes bietet. Dieser Prozess findet bei relativ hohen Temperaturen, ca. 220°C, statt. Beim Abkühlen verspannt sich das System typischerweise. Dadurch erfährt die integrierte Schaltung permanent eine mechanische Belastung, d. h. einen mechanischen Stress, vor allem an den Chipecken bzw. Chipkanten.

Durch Temperaturwechsel während des Betriebs kann dieser mechanische Stress zu Rissen im Chip führen, welche z.B. zu Unterbrechungen von elektrischen Leitungen führen und damit zum Ausfall des ASICs führen können, z. B. beschrieben in "Stress-Induced Deformation of Aluminum Metallization in Plastic Molded Semiconductor Devices", R. Thomas, IEEE Transactions on Components, Hybrids and Manufacturing Technology, 1985.

Um die Stabilität des ASICs sicherzustellen werden standardisierte Tests durchgeführt, z. B. JESD 22-A104.

Die bekannten technischen Lösungen beziehen sich darauf, den Stress entweder zu vermeiden, oder zumindest besonders gefährdete Stellen nicht mit kritischen Strukturen zu besetzen. Dadurch steht die Fläche in den Chipecken nicht für die Schaltung zur Verfügung.

Es ist ebenfalls bekannt, den Stress über piezoresistive Widerstände zu erfassen, wobei aus diesen Daten nicht direkt ein Bezug zu Rissen in der Metallisierung hergestellt werden kann, beispielsweise beschrieben in "In Situ Stress and Reliability Monitoring on Plastic Packaging Through Piezoresistive Stress Sensor", Yu-Yao Chang et al., IEEE transactions on components, packaging and manufacturing technology, vol. 3, no. 8, August 2013.

In-Situ ermittelte Daten über den mechanischen Stress werden genutzt, um kritische Schaltungsblöcke zu kompensieren. Dies ist beispielsweise in der Schrift DE 10 2011 004 848 A1 beschrieben.

Nachteilig ist hierbei, dass die Auslegung der durchgeführten Qualifikation auf Annahmen der tatsächlichen Feldbelastung basiert. Ist die tatsächliche Belastung eine höhere, besteht die Gefahr von Ausfällen trotz bestandener Qualifikation. Die Entstehung leichter Risse kann nur durch Öffnen des ASICs und anschließende Fehleranalyse detektiert werden - kritische Bereiche sind ja aus genannten Gründen elektrisch nicht aktiv. Eine Erkennung des Risses vor dem Ausfall der Schaltung ist nicht möglich.

Der Stress im ASIC selbst, wie er mit piezoresistiven Detektoren erfasst werden kann, ist nicht unbedingt ein Indiz für die Gefahr eines Risses in der Metallisierung. Tatsächlich nimmt der gemessene Stress solcher Detektoren aufgrund von Relaxationseffekten über die Zeit ab, während sich der Stress in der Metallisierung durch Materialverschiebung über die Anzahl der Temperaturzyklen aufbaut, bis es zu Rissen kommt.

Die Aufgabe der Erfindung ist es fehlerhafte Halbleiterchips zuverlässig zu erkennen.

### Offenbarung der Erfindung

Die MIM-Kapazität zur Rissdetektierung umfasst eine erste Metallschicht, eine Isolationsschicht und eine zweite Metallschicht. Die Isolationsschicht ist zwischen der ersten Metallschicht und der zweiten Metallschicht angeordnet. Erfindungsgemäß weist die Isolationsschicht eine Bruchzähigkeit kleiner 2MPa √m.

Der Vorteil ist hierbei, dass die MIM-Kapazität auf einfache Weise erzeugt werden kann.

In einer Weiterbildung weist die Isolationsschicht eine Zugspannung auf.

Vorteilhaft ist hierbei, dass die MIM-Kapazität überkritisch ist, sodass sich bei mechanischer Belastung schnell Risse bilden.

In einer weiteren Ausgestaltung weist die erste Metallschicht und/ oder die zweite Metallschicht eine Mohshärte kleiner 4 und eine Streckgrenze kleiner 200n/mm² auf.

Der Vorteil ist hierbei, dass bei der Ausbildung von Rissen ein Kurzschluss von der ersten Metallschicht zur zweiten Metallschicht erzeugt wird.

Der Rissdetektor umfasst eine MIM-Kapazität, die eine erste Metallschicht, eine Isolationsschicht und eine zweite Metallschicht aufweist. Die Isolationsschicht ist zwischen der ersten Metallschicht und der zweiten Metallschicht angeordnet. Erfindungsgemäß weist die Isolationsschicht eine Bruchzähigkeit kleiner 2MPa √m auf. Ein erstes metallisches Strukturelement ist oberhalb der ersten Metallschicht angeordnet, wobei das erste metallische Strukturelement eine erste mechanische Verbindung mit der ersten Metallschicht aufweist. Die erste mechanische Verbindung ist insbesondere eine erste Via. Ein zweites metallisches Strukturelement ist oberhalb der zweiten Metallschicht angeordnet, wobei das zweite metallische Strukturelement eine zweite mechanische Verbindung mit der zweiten Metallschicht aufweist. Die zweite mechanische Verbindung ist insbesondere eine zweite Via. Dadurch ist der Rissdetektor eingerichtet, mechanische Kräfte auf die MIM-Kapazität zu übertragen.

Vorteilhaft ist hierbei, dass mechanische Kräfte direkt auf die MIM-Kapazität wirken.

In einer Weiterbildung weist die Isolationsschicht eine Zugspannung auf.

Der Vorteil ist hierbei, dass der Rissdetektor schnell anschlägt.

In einer weiteren Ausgestaltung weist die erste Metallschicht und/oder die zweite Metallschicht eine Mohshärte kleiner 4 auf.

Vorteilhaft ist hierbei, dass sich bei einem Riss in der Isolationsschicht ein Kurzschluss bildet.

Ein Halbleiterchip umfasst einen Rissdetektor mit einer MIM-Kapazität, die eine erste Metallschicht, eine Isolationsschicht und eine zweite Metallschicht aufweist. Die Isolationsschicht ist zwischen der ersten Metallschicht und der zweiten Metallschicht angeordnet. Erfindungsgemäß weist die Isolationsschicht eine Bruchzähigkeit kleiner 2 MPa √m auf. Ein erstes metallisches Strukturelement ist oberhalb der ersten Metallschicht angeordnet, wobei das erste metallische Strukturelement eine erste mechanische Verbindung mit der ersten Metallschicht aufweist. Ein zweites metallisches Strukturelement ist oberhalb der zweiten Metallschicht angeordnet, wobei das zweite metallische Strukturelement eine zweite mechanische Verbindung mit der zweiten Metallschicht aufweist. Die MIM-Kapazität ist im oberen Bereich des Halbleiterchips angeordnet, insbesondere zwischen einer letzten Metallschicht und einer vorletzten Metallschicht, wobei die vorletzte Metallschicht gleichzeitig die erste Metallschicht der MIM-Kapazität umfasst, sodass der Rissdetektor eingerichtet ist, mechanische Kräfte auf die MIM-Kapazität zu übertragen. Mit anderen Worten die Vorrichtung zur Fehlerdetektion umfasst eine spezielle, bezüglich mechanischem Bruch überkritische MIM-Kapazität mit zugehöriger Metallschichttopographie.

Der Vorteil ist hierbei, dass zur Überwachung kritischer Bereiche des Halbleiterchips besonders sensible und einfache Elemente wie MIM-Kapazitäten verwendet werden, die keine Bedeutung für die tatsächliche Funktion des Schaltkreises haben, sodass sie ohne zusätzlichen Prozessierungsaufwand erzeugt werden können.

In einer Weiterbildung weist die Isolationsschicht eine Zugspannung auf.

In einer weiteren Ausgestaltung weist die erste Metallschicht und/oder die zweite Metallschicht eine Mohshärte kleiner 4 auf.

In einer Weiterbildung ist die MIM-Kapazität an einer kritischen Stelle des Halbleiterchips angeordnet, insbesondere an einem mechanischen Aufliegepunkt des Halbleiterbauelements während der Verarbeitung oder im finalen Zustand.

Der Vorteil ist hierbei, dass der Rissdetektor nur an vereinzelten Punkten des Halbleiterchips angeordnet sein muss.

In einer weiteren Ausgestaltung ist der Rissdetektor innerhalb des Halbleiterchips angeordnet.

In einer Weiterbildung ist der Rissdetektor an einer Kante oder Ecke des Halbleiterchips angeordnet.

In einer weiteren Ausgestaltung weist eine Passivierung jeweils mindestens eine Erhebung oberhalb des ersten Strukturelements und oberhalb des zweiten Strukturelements auf, sodass der Rissdetektor eingerichtet ist Scherkräfte zu erfassen.

Der Vorteil ist hierbei, dass die Richtung der einwirkenden Kraft ermittelbar ist.

Weitere Vorteile ergeben sich aus der nachfolgenden Beschreibung von Ausführungsbeispielen bzw. aus den abhängigen Patentansprüchen.

### Kurze Beschreibung der Zeichnungen

### Die vorliegende Erfindung wird nachfolgend anhand bevorzugter

Ausführungsformen und beigefügter Zeichnungen erläutert. Es zeigen:
- Figur 1: eine MIM-Kapazität,
- Figur 2: einen Rissdetektor,
- Figur 3: ein erstes Beispiel eines Halbleiterchips mit einem Rissdetektor,
- Figur 4: ein zweites Beispiel eines Halbleiterchips mit einem Rissdetektor,
- Figur 5: ein drittes Beispiel eines Halbleiterchips mit einem Rissdetektor,
- Figur 6: eine Draufsicht auf einen Halbleiterchip mit Topographie, und
- Figur 7: ein Verfahren zur Auswertung des Rissdetektors.

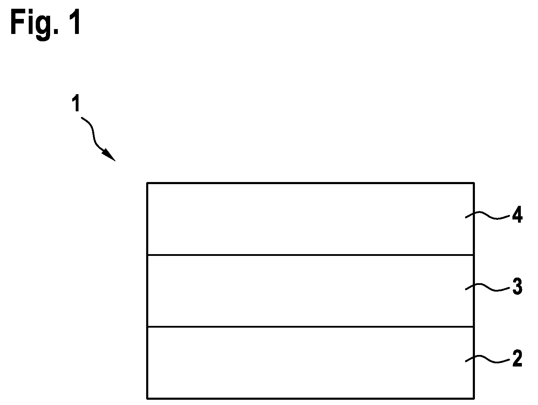

Figur 1 zeigt eine MIM-Kapazität 1 zur Rissdetektierung, die eine erste Metallschicht 2, eine Isolationsschicht 3 und eine zweite Metallschicht 4 aufweist. Die Isolationsschicht 3 ist zwischen der ersten Metallschicht 2 und der zweiten Metallschicht 4 angeordnet. Die Isolationsschicht 3 weist eine Bruchzähigkeit kleiner 2 MPa √m auf. Die Dicke der Isolationsschicht umfasst typischerweise einen Bereich von 5-100 nm. Das Material der Isolationsschicht 3 bzw. Dielektrikumsmaterial besteht typischerweise aus SiO₂, Si₃N₄ oder einer Schichtkombination der beiden. Dabei kann die erste Metallschicht 2, d. h. die unterliegende Metallschicht, oxidiert werden, z.B. mit TaO, sodass sich die Isolationsschicht 2 bildet.

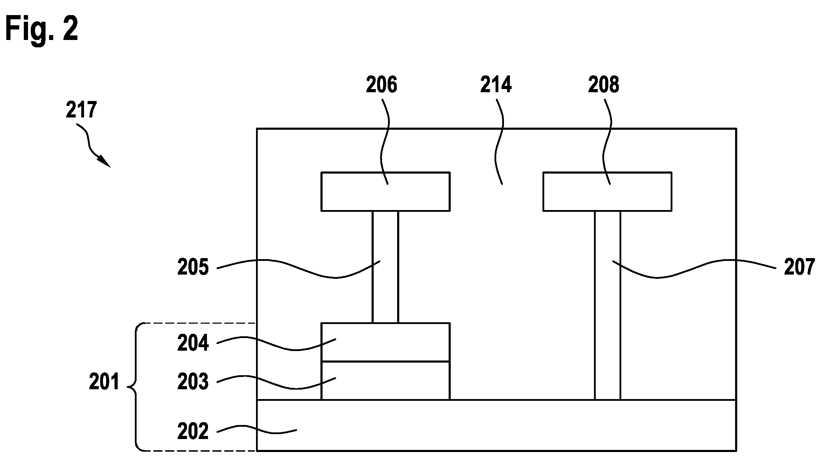

Figur 2 zeigt einen Rissdetektor 217 mit einer MIM-Kapazität 201. Oberhalb der ersten Metallschicht 202 ist ein erstes metallisches Strukturelement 206 angeordnet. Ein erstes metallisches Strukturelement 208 ist mittels einer ersten Via 207 mit der ersten Metallschicht 202 verbunden. Ein zweites metallisches Strukturelement 206 ist mittels einer zweiten Via 205 mit der zweiten Metallschicht 204 verbunden. Die erste Via 207 und die zweite Via 205 dienen dabei zur Kräfteübertragung von einer oberen Metallebene, die das erste metallische Strukturelement 208 und das zweite metallische Strukturelement 206 umfasst. Die MIM-Kapazität 201, das erste metallische Strukturelement 208 und das zweite metallische Strukturelement 206, sowie die erste Via 207 und die zweite Via 205 sind in einem isolierenden Material, zum Beispiel Siliziumsdioxid eingebettet.

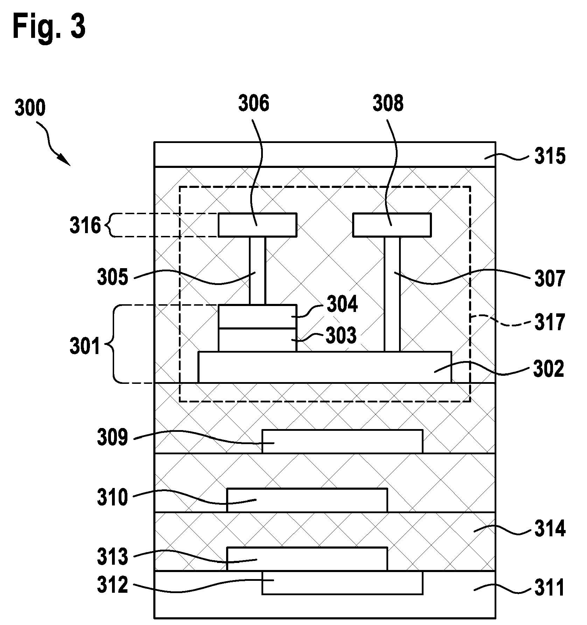

Figur 3 zeigt ein erstes Beispiel eines Halbleiterchips 300 mit einem Rissdetektor 317. Der Halbleiterchip 300 weist ein Halbleitersubstrat 311 auf. Ausgehend von der Oberfläche des Halbleitersubstrats 311 ist bereichsweise ein Feldoxid 312 in das Halbleitersubstrat 311 eingebracht. Auf dem Halbleitersubstrat 311 ist bereichsweise ein Polysilizium 313 aufgebracht, dass sich teilweise über das Feldoxid 312 ausbreitet. Auf das Polysilizium 313 ist eine Schicht 314 aus Siliziumsdioxid aufgebracht. Auf die Schicht 314 ist eine weitere Metallschicht 310 aufgebracht, die ebenfalls von einer weiteren Schicht 314 aus Siliziumsdioxid umgeben ist. Auf diese weitere Schicht 314 ist eine weitere Metallschicht 309 aufgebracht, die ebenfalls von einer weiteren Schicht 314 aus Siliziumsdioxid umgeben ist. Auf diese weitere Schicht 314 ist der Rissdetektor 317 aufgebracht. Auf dem Rissdetektor 317 ist eine Passivierungsschicht 315 angeordnet. Die MIM-Kapazität 301 des Rissdetektors ist vorzugsweise zwischen der obersten und der vorletzten Metalllage des Halbleiterchips 300 angeordnet. Die weiteren Metallschichten 309 und 310 stellen eine beispielhafte integrierte Schaltung dar, d. h. die beispielhafte integrierte Schaltung weist eine Vielzahl von Bauelementen und Strukturen auf, z. B. Metal 1, 2, ... n, die nicht dem Rissdetektor bzw. dem Detektor zugehörig sind. Mit anderen Worten die Anzahl der weiteren Metallschichten und der weiteren Schichten aus Siliziumdioxid ist beliebig und nicht auf die Anzahl zwei beschränkt. Die weiteren Metallschichten 309 und 310 sind für die eigentliche Funktion der integrierten Schaltung und für eine Auswerteeinheit des Rissdetektors von Bedeutung. Die zweite Metallschicht 304, die als Elektrode über der Isolationsschicht 302 bzw. dem Dielektrikum angeordnet ist, ist dünn. Dadurch kann der mechanische Stress möglichst direkt auf das Dielektrikum wirken. Der Rissdetektor 317 weist zusätzlich eine Auswerteeinheit auf, die in Figur 3 nicht gezeigt ist. Diese Auswerteeinheit erzeugt ein Ausgangssignal, das anzeigt ob der Halbleiterchip einen Riss aufweist.

In einem Ausführungsbeispiel steht die Isolationsschicht 303 unter Zugspannung. Dadurch weitet sich ein entstehender Riss schnell aus. Eine solche Zugspannung kann durch Anpassung der Abscheidebedingungen der Schicht, z. B. Druck, Temperatur, Gasflüsse, Leistung, eingestellt werden.
Zumindest eine der die MIM-Kapazität 301 bildenden Metallschichten 302 und 304 sollte ausreichend weich, d. h. Mohshärte < 4, bzw. fließfähig, d. h. Streckgrenze < 200 N/mm², sein, sodass sie einen Kurzschluss zur anderen Elektrode bilden kann, wenn ein Riss durch die Isolationsschicht 303 entsteht.

Entsteht ein Riss in den dielektrischen Schichten an der Chipoberfläche, setzt sich dieser in die MIM-Kapazität 301 fort. Aufgrund der dünnen dielektrischen Schicht 303 führt ein solcher Riss sehr schnell zu einem elektrischen Kurzschluss, der über entsprechende Auswerteschaltungen, z. B. Leckstromerkennung bzw. Widerstandsmessung zwischen den beiden Elektroden, d. h. der ersten Metallschicht 302 und der zweiten Metallschicht 304 einfach erkannt werden kann. Je nach Größe des Risses ändert sich der Widerstand zwischen den beiden Elektroden der MIM-Kapazität von typischerweise mehreren MΩ auf relativ niedrige Werte, z.B. <10 kΩ.

Ein Halbleiterchip bzw. ASIC kann einen oder mehrere dieser Rissdetektoren an kritischen Stellen des ASICs integrieren. Diese Rissdetektoren können einzeln geprüft werden, oder in Gruppen per Parallelschaltung zusammengefasst sein.

Kritische Stellen sind im Allgemeinen Chipecken bzw. Chipkanten sein. Aber gerade bei Sensorsystemen, in welchen mehrere Subkomponenten (ASIC, MEMS, passive Komponenten, ...) miteinander oder übereinander verbaut sind, kann sich eine solch kritische Stelle durchaus auch im Chipinneren befinden - zum Beispiel am Aufliegepunkt eines auf dem Schaltkreis montierten MEMS-Elements. Auch Stellen des ASICs, welche typischerweise mechanisch belastet werden, können so abgeprüft werden, z.B. Vakuum-Nozzle beim "Pick- and Place"-Prozess.

Um Kraftübertrag von Scherkräften auf den Detektor zu ermöglichen, kann über dem Detektor eine zusätzliche Topographie erzeugt werden, z.B. durch Design einer Topmetal-Struktur von geeigneter Dimension und Richtung, typischerweise quer zur Richtung des erwarteten mechanischen Stresses. Solche Topographien sind in den

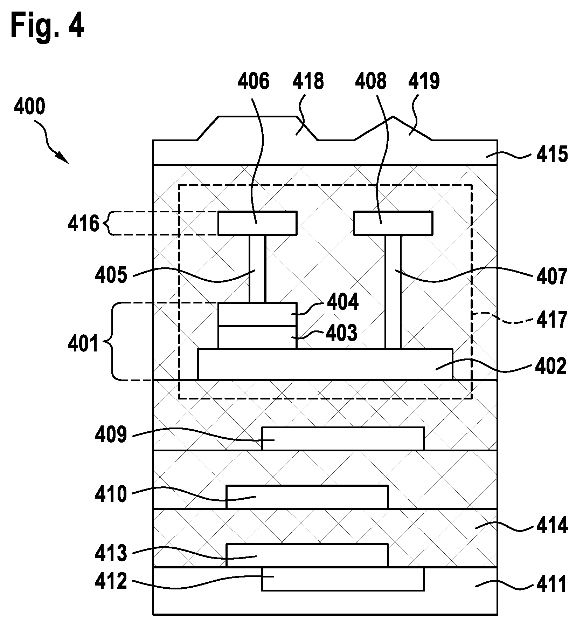

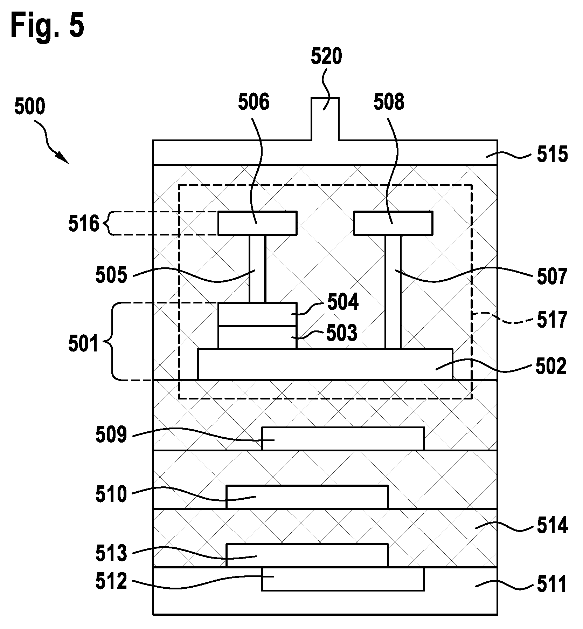

Figuren 4 und 5 gezeigt. Die Figuren 4 und 5 entsprechen im Wesentlichen Figur 3, wobei gleiche Merkmale des Halbleiterchips identische hintere Stellen der Bezugszeichen aufweisen. Die zusätzliche Topographie bzw. die Erhebungen 418, 419 und 520 umfassen Materialien wie Cu, Ni, Pd oder einer Legierung aus diesen Metallen. Die Höhe der Topographien ist beispielsweise 10 µm.

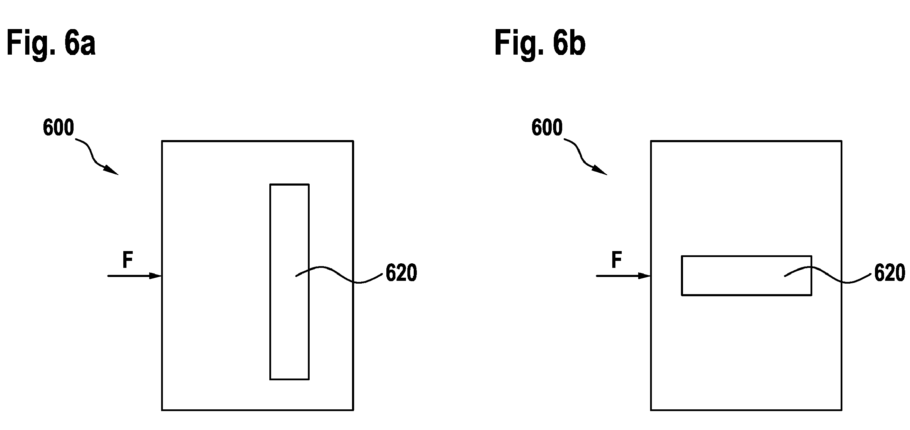

Figur 6 zeigt die Draufsicht auf einen Halbleiterchip 600, der eine Topographie 620 nach Figur 5 aufweist. Figur 6a zeigt dabei einen Halbleiterchip 600, der eine Topographie 620 aufweist, die senkrecht zur anliegenden Kraft bzw. zum anliegenden Stress angeordnet ist. Der Rissdetektor reagiert, d. h. die Auswerteeinheit erzeugt ein Ausgangssignal, da in der MIM-Kapazität ein Kurzschluss aufgetreten ist. Figur 6b zeigt denselben Halbleiterchip 600 wobei in diesem Fall die Topographie 620 parallel zur anliegenden Kraft bzw. zum anliegenden Stress angeordnet ist.

In einem Ausführungsbeispiel können mehrere Rissdetektoren auf einem gemeinsamen Schaltkreis in direkter Nähe zueinander eingesetzt werden, wobei sie solche Topographien in unterschiedlichen Richtungen integrieren. Hierbei können die Detektoren die untere Elektrode, d. h. die erste Metallschicht 302, gemeinsam nutzen. Falls die Richtungsinformation nicht ausgewertet werden soll, sondern nur mehrere Richtungen gleichzeitig analysiert werden sollen, kann auch die obere Elektrode, d. h. die zweite Metallschicht 302 gemeinsam sein.

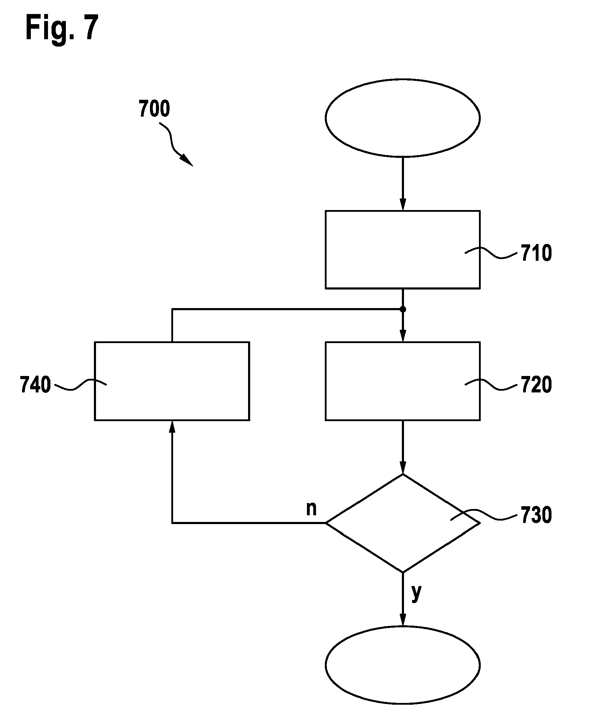

Figur 7 zeigt ein Verfahren zur Auswertung des Rissdetektors. Das Verfahren 700 startet mit einem Schritt 710, in dem ein erstes Rissdetektorsignal zu einem ersten Zeitpunkt erfasst wird. Das erste Rissdetektorsignal repräsentiert hierbei einen Wert des Widerstands der MIM-Kapazität zum ersten Zeitpunkt. Dieses erste Rissdetektorsignal wird in einem Speicher der Auswerteeinheit als erster Referenzwert hinterlegt bzw. gespeichert. In einem folgenden Schritt 720 wird ein zweites Rissdetektorsignal zu einem zweiten Zeitpunkt erfasst. Das zweite Rissdetektorsignal repräsentiert hierbei den Wert des Widerstands der MIM-Kapazität zum zweiten Zeitpunkt. In einem folgenden Schritt 730 wird in Abhängigkeit des des ersten Rissdetektorsignals und des zweiten Rissdetektorsignals ein Ausgangssignal erzeugt. Das Ausgangssignal repräsentiert hierbei die Funktionsfähigkeit des Halbleiterchips. Sind die Werte des ersten Rissdetektorsignals und des zweiten Rissdetektorsignals im Wesentlichen identisch, so ist der Halbleiterchip funktionsfähig. Ist der Wert des zweiten Rissdetektorsignals wesentlich kleiner, d. h. um Größenordnungen, als das erste Rissdetektorsignal, liegt ein Kurzschluss in der MIM-Kapazität vor, d. h. der Rissdetektor hat einen Riss erkannt. Das bedeutet der Halbleiterchip ist fehlerbehaftet. Das Verfahren wird beendet. Liegt kein Fehler vor, so wird das zweite Rissdetektorsignal in einem Schritt 740 im Speicher der Auswerteeinheit als zweiter Referenzwert gespeichert. Optional kann der zweite Referenzwert den ersten Referenzwert überschreiben.

In einem Ausführungsbeispiel ist der erste Zeitpunkt der des Wafertests. Dabei wird die Funktion der Struktur geprüft und das Rissdetektorsignal als Initialwert gespeichert. Der zweite Zeitpunkt kann beispielsweise zeitlich nach dem Verpackungsprozess im finalen Testschritt sein, um den Einfluss des Verpackungsprozesses zu überprüfen.

In einem weiteren Ausführungsbeispiel kann der zweite Zeitpunkt der jeweilige Zeitpunkt einer Startprozedur im Feld sein.

Für sicherheitskritische Anwendungen kann das Verfahren auch in-situ permanent im Feld ausgeführt werden.

## Patentansprüche

1. MIM-Kapazität (1) zur Rissdetektierung umfassend eine erste Metallschicht (2), eine Isolationsschicht (3) und eine zweite Metallschicht (4), wobei die Isolationsschicht (3) zwischen der ersten Metallschicht (2) und der zweiten Metallschicht (4) angeordnet ist, **dadurch gekennzeichnet dass** die Isolationsschicht (3) eine Bruchzähigkeit kleiner 2MPa √m aufweist.

2. MIM-Kapazität (1) nach Anspruch 1, **dadurch gekennzeichnet, dass** die Isolationsschicht (3) eine Zugspannung aufweist.

3. MIM-Kapazität (1) nach einem der Ansprüche 1 oder 2, **dadurch gekennzeichnet, dass** die erste Metallschicht (2) und/oder die zweite Metallschicht (4) eine Mohshärte kleiner 4 aufweist.

4. Rissdetektor (217) mit einer MIM-Kapazität (201), die eine erste Metallschicht (202), eine Isolationsschicht (203) und eine zweite Metallschicht (204) aufweist, wobei die Isolationsschicht (203) zwischen der ersten Metallschicht (202) und der zweiten Metallschicht (204) angeordnet ist, **dadurch gekennzeichnet, dass** die Isolationsschicht (203) eine Bruchzähigkeit kleiner 2MPa √m aufweist und ein erstes metallisches Strukturelement (208) oberhalb der ersten Metallschicht (202) angeordnet ist, wobei das erste metallische Strukturelement (208) eine erste mechanische Verbindung (207), insbesondere eine erste Via (207), mit der ersten Metallschicht (202) aufweist und ein zweites metallisches Strukturelement (206) oberhalb der zweiten Metallschicht (204) angeordnet ist, wobei das zweite metallische Strukturelement (206) eine zweite mechanische Verbindung (205), insbesondere eine zweite Via (205), mit der zweiten Metallschicht (204) aufweist, sodass der Rissdetektor (217) eingerichtet ist, mechanische Kräfte auf die MIM-Kapazität (201) zu übertragen.

5. Rissdetektor (217) nach Anspruch 4, **dadurch gekennzeichnet, dass** die Isolationsschicht (203) eine Zugspannung aufweist.

6. Rissdetektor (217) nach einem der Ansprüche 4 oder 5, **dadurch gekennzeichnet, dass** die erste Metallschicht (202) und/oder die zweite Metallschicht (204) eine Mohshärte kleiner 4 aufweist.

7. Halbleiterchip (300) umfassend einen Rissdetektor (317) mit einer MIM-Kapazität (301), die eine erste Metallschicht (302), eine Isolationsschicht (303) und eine zweite Metallschicht (304) aufweist, wobei die Isolationsschicht (303) zwischen der ersten Metallschicht (302) und der zweiten Metallschicht (304) angeordnet ist, **dadurch gekennzeichnet, dass** die Isolationsschicht (303) eine Bruchzähigkeit kleiner 2MPa √m aufweist und ein erstes metallisches Strukturelement (308) oberhalb der ersten Metallschicht (302) angeordnet ist, wobei das erste metallische Strukturelement (308) eine erste mechanische Verbindung (307), insbesondere eine erste Via (307), mit der ersten Metallschicht (302) aufweist und ein zweites metallisches Strukturelement (306) oberhalb der zweiten Metallschicht (304) angeordnet ist, wobei das zweite metallische Strukturelement (306) eine zweite mechanische Verbindung (305), insbesondere eine zweite Via (305), mit der zweiten Metallschicht (304) aufweist, wobei die MIM-Kapazität (301) im oberen Bereich des Halbleiterchips (300) angeordnet ist, insbesondere zwischen einer letzten Metallschicht (316) und einer vorletzten Metallschicht, wobei die vorletzte Schicht gleichzeitig die erste Metallschicht (302) der MIM-Kapazität (301) umfasst, wobei der Rissdetektor (317) eingerichtet ist, mechanische Kräfte auf die MIM-Kapazität (301) zu übertragen.

8. Halbleiterchip (300) nach Anspruch 7, **dadurch gekennzeichnet, dass** die Isolationsschicht (303) eine Zugspannung aufweist.

9. Halbleiterchip (300) einem der Ansprüche 7 oder 8, **dadurch gekennzeichnet, dass** die erste Metallschicht (302) und/oder die zweite Metallschicht (304) eine Mohshärte kleiner 4 aufweist.

10. Halbleiterchip (300) nach Anspruch 7, **dadurch gekennzeichnet, dass** die MIM-Kapazität (301) an einer kritischen Stelle des Halbleiterchips (300) angeordnet ist, vorzugsweise an einem Aufliegepunkt eines Halbleiterbauelements.

11. Halbleiterchip (300) nach einem der Ansprüche 7 bis 10, **dadurch gekennzeichnet, dass** der Rissdetektor (317) innerhalb des Halbleiterchips (300) angeordnet ist.

12. Halbleiterchip (300) nach einem der Ansprüche 7 bis 11, **dadurch gekennzeichnet, dass** der Rissdetektor (317) an einer Kante oder Ecke des Halbleiterchips (300) angeordnet ist.

13. Halbleiterchip (300) nach einem der Ansprüche 7 bis 12, **dadurch gekennzeichnet, dass** eine Passivierungsschicht (315) jeweils mindestens eine Erhebung oberhalb des ersten Strukturelements (308) und oberhalb des zweiten Strukturelements (306) aufweist, sodass der Rissdetektor (371) eingerichtet ist Scherkräfte zu erfassen.

14. Verfahren (700) zur Auswertung des Rissdetektors mit den Schritten:
• Erfassen (710) eines ersten Rissdetektorsignals zu einem ersten Zeitpunkt,
• Erfassen (720) eines zweiten Rissdetektorsignals zu einem zweiten Zeitpunkt,
• Erzeugen (730) eines Ausgangssignals in Abhängigkeit des ersten Rissdetektorsignals und des zweiten Rissdetektorsignals.
